# EUROPÄISCHE PATENTSCHRIFT

(11) **EP 1 593 142 B1**
(45) Veröffentlichungstag und Bekanntmachung des Hinweises auf die Patenterteilung: **14.11.2007**
(21) Anmeldenummer: 04709164.0
(22) Anmeldetag: 09.02.2004
(51) Int. Cl.: H01J 37/32, C23C 14/56, C21D 9/56

(54) **ANLAGE ZUR MAGNETFELDBEEINFLUSSTEN PLASMAPROZESSIERUNG EINES ENDLOSMATERIALS**
MAGNETICALLY ENHANCED PLASMA PROCESSING INSTALLATION FOR CONTINUOUS MATERIAL
INSTALLATION POUR TRAITEMENT D'UN MATERIAU CONTINU AU PLASMA INTENSIFIE MAGNETIQUEMENT

(30) Priorität: 12.02.2003 AT 2082003; 30.01.2004 AT 1282004
(43) Veröffentlichungstag der Anmeldung: 09.11.2005
(73) Patentinhaber: Ziger, Peter, A-8010 Graz (AT)
(72) Erfinder: ZIGER, Peter, A-8010 Graz (AT); JÄGER, Helmut, A-8071 Hausmannstätten (AT); NEUREITER, Christian, A-8010 Graz (AT)
(74) Vertreter: Margotti, Herwig Franz
(86) Internationale Anmeldenummer: PCT/AT2004/000043
(87) Internationale Veröffentlichungsnummer: WO 2004/073009

(56) Entgegenhaltungen:
- EP-A- 0 313 154
- EP-A- 0 966 021
- EP-A- 0 981 150
- EP-A- 1 178 134
- DE-A- 2 157 606
- DE-A- 3 041 095
- DE-A- 4 211 167
- DE-A- 10 001 381
- DE-A- 19 907 911
- FR-A- 2 774 400
- US-A- 3 211 886
- US-A- 3 884 793
- US-A- 4 842 704
- US-A- 4 950 450
- US-A- 4 950 956
- US-A- 5 234 560
- US-A- 5 317 006
- US-A- 5 490 910
- PATENT ABSTRACTS OF JAPAN Bd. 0061, Nr. 14 (C-110), 25. Juni 1982 (1982-06-25) -& JP 57 041318 A (NIPPON STEEL CORP), 8. März 1982 (1982-03-08)

## Beschreibung

Die Erfindung betrifft eine Anlage zur magnetfeldbzeinflussten Plasmaprozessierung eines Endlosmaterials, umfassend wenigstens eine evakuierbare Entladungskammer, darin eine äußere Elektrode, insbesondere Anode, die elektrisch isoliert um das Endlosmaterial angeordnet ist, eine Einrichtung zur Einstellung einer Gas-Atmosphäre in der wenigstens einen Entladungskammer, eine Energieversorgungseinrichtung zur Bereitstellung einer(s) für eine Gasentladung zwischen dem Endlosmaterial als innere Elektrode, insbesondere Kathode, und der äußeren Elektrode ausreichenden Spannung bzw. Stroms, wobei zur beträchtlichen Erhöhung der erzielbaren Energiedichte der Gasentladung im Bereich der äußeren Elektrode, vorzugsweise außerhalb der äußeren Elektrode, eine Hochleistungsmagnetanordnung zur Erzeugung eines Magnetfelds, insbesondere von wenigstens 50mT, vorzugsweise von wenigstens 100mT, gegebenenfalls von über 400mT, angeordnet ist, umfassend eine Führungseinrichtung zum kontinuierlichen Transport des Endlosmaterials durch die wenigstens eine Entladungskammer, wobei das Magnetfeld der Hochleistungsmagnetanordnung im Wesentlichen parallel zum Endlosmaterial ausgerichtet ist, wobei die Einrichtung zur. Einstellung einer Gas-Atmosphäre ein Vorkammern- und ein Nachkammernsystem umfasst, wobei zwischen den Kammern dieser Systeme Schleusenöffnungen vorgesehen sind, durch welche das Endlosmaterial reibungsarm durch das Vorkammern- und das Nachkammernsystem hindurch führbar ist.

Plasmaprozessierung wird zur Behandlung von Werkstücken bzw. von Endlosmaterial zur Erhitzung, zur Reinigung, zur (De-)Oxidation, zur Entfettung, anderer Abtragung, Bedampfung, Sputterung oder anderen Beschichtungen eingesetzt. Herkömmliche Anlagen zur Plasmaprozessierung eines Endlosmaterials oder eines WerkStüCkS erzeugen Plasmastromdichten von lediglich einigen mA/cm², die eine relative lange Prozessdauer erforderlich machen. Dies bedeutet für die Bearbeitung von Endlosmaterial relativ langsame Durchführungsgeschwindigkeiten und für die eines Werkstücks lange Verweildauern in der Anlage, was wiederum mit erheblichen Kosten verbunden ist.

Aus der US 3 211 886 wurde ein Apparat zur Reinigung von elektrisch leitendem Langmaterial Hilfe einer Bogenentladung bekannt. Zwei Spulen erzeugen um die Entladungszone ein zum Langmaterial paralleles Magnetfeld. Prozessgas wird dem Entladungsraum zugeführt und über einen Abzug dem Entladungsraum entnommen rückgewonnen.

Nachteilig an der Einrichtung der US 3 211 886 ist, dass die Führungsmuffen mit dem Langmaterial reiben und daher die Prozessgeschwindigkeit begrenzt ist und weiters die Anlage für Langmaterial lediglich eines Durchrnessers geeignet ist. Die Verwendung größerer Führungsmuffen im Vergleich zum Langmaterial bzw, die Prozessierung von Langmaterial mit Durchmessern, die u.U. erheblich kleiner sind als die Öffnung der Führungsmuffen, hätte allerdings einen erheblichen Verlust von Prozessgasen zur Folge.

Aus der EP 1 178 134 A geht ein Verfahren und eine Vorrichtung zur Plasmadurchlaufbehandlung metallischer Substrate hervor, die einem Plasma und einem Magnetfeld zwischen Substrat und Gegenelektrode ausgesetzt werden. Das Plasma wird hierbei durch das Magnetfeld gleichmäßig um das ganze Substrat begrenzt, indem freie Elektronen auf einen Bereich innerhalb des Plasmas begrenzt werden.

Die US 5 317 006 A offenbart eine Kathode für ein Sputteringsystem, umfassend einen metallischen äußeren Zylinder und in diesem Zylinder ein in einem polygonalen Querschnitt angeordnetes Targetmaterial zur Ausbildung eines Films aus hochtemperatursupraleitendem Material auf einem Substrat im Inneren der polygonalen Form.

Die EP 0 313 154 A offenbart eine Spule zur Erzeugung eines Magnetfelds zur Erhöhung der Plasmadichte, enthält jedoch keinen Hinweis auf Hochleisningsmagnetfelder jenseits der 50mT.

Die JP 57 041318 A zeigt eine Rückgewinnung eines Prozessgases aus einem Wärmebehandlungsofen, bei dem das Prozessgas über ein Gebläse lediglich aus der Heizzone rückgewonnen wird. Eine Magnetanordnung wird nicht gezeigt.

Aufgabe der Erfindung besteht darin, eine Anlage zur Plasmaprozessierung gemäß Oberbegriff des Anspruchs 1 anzugeben, die nicht nur hohe Plasmastromdichten, insbesondere in der Größenordnung von einem A/cm², erzeugen kann und somit deutlich höhere Prozessgeschwindigkeiten erlaubt, sondern es auch ermöglicht, daß besonders gas-sparend prozessiert werden kann, was insbesondere bei teuren Prozessgasen wie Helium von Bedeutung ist.

Erfindungsgemäß wird dies dadurch erreicht, dass die Einrichtung zur Einstellung einer Gas-Atmosphäre ein Rückgewinnungssystem umfasst, bei dem Gas aus einer Nachkammer in eine Vorkammer und/oder Nachkammer mit höherem Druckniveau umwälzbar ist. Weiters kann erfindungsgemäß durch Schlensen öffnungen zwischen den Kammern und Führung bei besonders hohen möglichen Prozessgeschwindigkeiten gleichzeitig die für die Gasentladung erforderliche Gasatmosphäre aufrecht erhalten werden. Eine solche Anlage ist zur effizienten Behandlung von Endlosmaterial besonders gut geeignet.

Durch die Erzeugung derart starker Magnetfelder, insbesondere normal zur Entladungsrichtung, können besonders hohe Plasmastromdichten, insbesondere im Bereich von A/cm², erzeugt werden. Die Ladungsträger werden hierbei von der Lorenzkraft umgelenkt, wobei die Krümmungsradien der Elektronen kleiner sind oder maximal in der gleichen Größenordnung wie die freien Weglängen der Plasmateilchen (typisch im Zehntelmilimeterbereich) liegen.

Durch das Magnetfeld wird das Plasma leitfähiger, so dass die Entladung vorzugsweise nur im magnetfelddurchdrungenen Volumen brennt.

Das Plasma kann bei einem gegebenen Druck gezündet werden und es können sehr große Ströme durchgeleitet werden, ohne dass das Plasma aus dem Magnetfeld "hinausbrennt". Man kommt also für den gesamten Prozess mit einem einzigen Wert für den Druck aus.

Dazu kommt, dass die Zündspannung des Plasmas in die Nähe der Brennspannung reduziert wird, das die sonst bei Glimmentladungsanordnungen üblicherweise eingesetzten speziellen Zündanordnungen, Prozeduren oder anderen Zündhilfsmittel überflüssig macht.

Am wichtigsten aber ist, dass die zu einem entstehenden Bogenkanal senkrecht stehende Magnetfeldkomponente den Bogen stark behindert, da aus dem leitenden Kanal Elektronen durch die magnetische Kraft hinausgeschleudert werden. Somit können mit dieser Anordnung pro Elektrodenlängeneinheit wesentlich größere Ströme durch das Plasma geleitet werden, ohne dass ein Bogen entsteht. Infolge dessen kann das Endlosmaterial bei gleichem Behandlungseffekt (z.B.: bei gleicher zu erzielender Erwärmung) schneller prozessiert werden, was letzen Endes eine wesentliche Vergrößerung des Outputs der gesamten Anlage ermöglicht.

Weiters bleiben die Brennzonen räumlich definiert Da das Plasma durch das Magnetfeld räumlich eingeschränkt wird, hat man hiermit auch eine Maßnahme gegen die Bildung von "Hotspots" in der Hand: Überhitzte Teile können nun nicht mehr einen überproportionalen Anteil des Stroms an sich ziehen. Außerdem ist durch die höhere Ionisierung im Volumen das Plasma weniger von den Sekundärelektronen abhängig. Des weiteren werden gleiche Ladungsträgerdichten nun mit weniger Teilchen, also bei geringerem Druck produziert - das Plasma brennt also bei gleicher Leistung bei einem niedrigeren Druck. Dies fördert auch eine bessere Teilchendurchmischung. All dies hemmt die Bildung der Hotspots.

In besonderer Ausgestaltung der Erfindung kann vorgesehen sein, dass die Hochleistungsmagnetanordnung als supraleitender Elektromagnet ausgebildet ist.

Supraleitende Elektromagnete sind geeignet, die erforderlichen hohen Magnetfelder zu erzeugen und bieten darüber hinaus den Vorteil, dass mit ihnen durch eine Regelung des diese durchfließenden Stromes auch ein regelbares Magnetfeld erzeugt werden kann, sodass das Magnetfeld leicht auf bestimmte Anwendungen angepasst werden kann.

In einer anderen Ausgestaltung der Erfindung kann vorgesehen sein, dass die Hochleistungsmagnetanordnung als Pernianentmagnetanordriung ausgebildet ist.

Der Einsatz von Permanentmagneten bringt den Vorteil mit sich, dass zur Erzeugung eines Magnetfeldes kein zusätzlicher Strom erforderlich ist, weswegen der Betrieb der Anlage kostengünstiger ist.

Insbesondere kann vorgesehen sein, dass die Permanentmagnetanordnung aus Permanentmagneten, insbesondere aus anisotropen Permanentmagneten, vorzugsweise aus NdFeB-Permanentmagneten, aufgebaut ist, welche im Wesentlichen die Seitenwände eines Prismas mit polygonalem Querschnitt bilden.

Durch den Aufbau einer Permanentmagnetanordnung aus Permanentmagneten in Form eines Prismas können besonders günstige Magnetfeldverläufe in der Entladungskammer einfach realisiert werden. Der Einsatz anisotroper Permanentmagnete, vorzugsweise von NdFeB-Permanentmagneten, ermöglicht die Erzeugung besonders Starker Magnetfelder.

In besonderer Ausgestaltung der Erfindung kann vorgesehen sein, dass der Querschnitt des Prismas als Quadrat oder Sechseck ausgebildet ist.

Diese Ausführungen sind besonders einfach zu realisieren.

In Weiterbildung der Erfindung kann vorgesehen sein, dass Eisenschlusselemente vorgesehen sind, die das Magnetfeld der Permanentmagnetanordnung im Bereich der Gasentladung konzentrieren.

Durch die relativ kostengünstigen Eisenschlusselemente kann die Wirkung der Permanentmagnete im Bereich der Gasentladung deutlich erhöht werden.

In besonderer Ausgestaltung der Erfindung kann vorgesehen sein, dass die Permanentmagnete jeweils im Wesentlichen normal zu an diese angrenzenden Eisenschlusselemente angeordnet sind, sodass jeweils genau ein Pol eines Permanentmagnetes am Eisenschlusselement anliegt.

So kann mit einer relativ geringen Anzahl von Permanentmagneten ein starkes im Wesentlichen homogenes Magnetfeld im Bereich der gewünschten Gasentladung konzentriert werden.

In besonderer Ausgestaltung der Erfindung kann vorgesehen sein, dass eine Vorrichtung zur Abstimmung der Magnetfelder der Permanentmagnete mit definierten begrenzten Stromverläufen vorgesehen ist.

So kann die Anlage mit geringem Aufwand auf geänderte Anforderungen abgestimmt werden. Die definierten begrenzten Stromverläufe können auch zur Entmagnetisierung von Permanentmagneten eingesetzt werden.

insbesondere kann vorgesehen sein, dass wenigstens ein Permanentmagnet und/oder wenigstens ein Eisenschlusselement entfernbar, ersetzbar, verschiebbar oder verdrehbar angeordnet ist.

So kann die Anlage mir geringem Aufwand auf geänderte Anforderungen abgestimmt werden, ohne dass einzelne Permanentmagnete ummagnetisiert werden müssten.

Weiters kann vorgesehen sein, dass die äußeren Elektroden und/oder die Hochleisturtgsmagnetanordnung kühlbar, insbesondere flüssigkeitskühlbar, sind.

So kann eine Überhitzung dieser Elemente zuverlässig vermieden werden.

In einer besonderen Ausgestaltung der Erfindung kann vorgesehen sein, dass die Einrichtung zur Einstellung einer bestimmten Gas-Atmosphäre ein Regel- bzw. Steuersystem mit Vakuumpumpen, vorzugsweise Drehschieberpumpen, und/oder Ventilen umfasst, mit denen die Gas-Atmosphäre auf einen auf eine gewähltes Gas-Atmosphäre abgestimmten Druck einstellbar ist.

So kann der für eine bestimmte Anwendung erforderliche Gasdruck leicht hergestellt werden. Insbesondere Drehschieberpumpen erweisen sich hierbei als kostengünstige und dennoch ausreichende Variante.

Insbesondere kann vorgesehen sein, dass die Einrichtung zur Einstellung einer Gas-Atmosphäre auf Edelgase, insbesondere auf Helium, einstellbar ist.

So kann der sichere Betrieb der Anlage mit Edelgasen gewährleistet werden.

In besonderer Ausgestaltung der Erfindung kann vorgesehen sein, dass die Einrichtung zur Einstellung einer Gas-Atmosphäre auf Edelgase, insbesondere auf Helium, Argon oder Krypton, mit einer Beimengung von vorzugsweise ein bis zehn, speziell ein bis drei Prozent, eines chemisch wirksamen, insbesondere oxidierenden oder reduzierenden, Gases oder Dampfes, wie beispielsweise Wasserstoff, ein Alkohol oder ein Alkan, einstellbar ist.

Bei einer derartigen Einstellung werden die vorteilhaften Eigenschaften von Helium (gefahrlos, relativ gutes Kühlgas) und Wasserstoff (hervorragendes Kühlgas, im Vergleich zu Helium gut ionisierbar, reinigende Wirkung durch Deoxidation) in besonders zweckmäßiger Weise kombiniert. Edelgas wirkt als Energiepumpe, die atomare Zustände mit hoher Anregungsenergie und langen Verweildauern bildet wobei das chemisch wirksame Gas oder der Dampf in einen energetisch höheren Zustand gebracht wird (Ion, angeregtes Atom, freies Radikal ...) und seine chemische Wirksamkeit voll entfaltet.

In weiterer Ausgestaltung der Erfindung kann vorgesehen sein, dass die Energizvezsorgungseinrichtung auf Gleichspannung, insbesondere gepulste Gleichspannung, zwischen äußerer Elektrode und Endlosmaterial bzw. Werkstück abgestimmt ist, wobei die Pulse z.T. auch umgekehrte oder wechselnde Polarität aufweisen können.

Gleichspannung ist für eine Gasentladung im vorliegenden Fall geeignet. Eine gepulste Gleichspannung unterdrückt den unerwünschten Übergang der Gasentladung zu einer Bogenentladung mit festem Brennfleck. Für verschiedene Prozesse können unterschiedliche Spannungs- bzw. Stromverläufe der Pulse von Vorteil sein, wie beispielsweise Rechtecksspannungen bzw. Rechtecksstromverläufe.

In Weiterbildung der Erfindung kann vorgesehen sein, dass die Vorkammern in Unterkammern unterteilt sind und/oder das Nachkammernsystem aus einzelnen Nachkammern zusammengesetzt ist, wobei zwischen den Unterkammern bzw. den Nachkammern Schleusenöffnungen vorgesehen sind, über welche das Endlosmaterial reibungsarm durch die Unterkammern bzw. die Nachkammern hindurch führbar ist.

Die Ausbildung von Unterkammern und Nachlcammern ermöglicht auch bei reibungsarmer Führung des Endlosmaterials eine sichere Aufrechterhaltung der gewünschten Atmosphäre in der Entladungskammer und verhindert das unerwünschte Eintreten von Luft in dieselbe.

In besonderer Ausgestaltung der Erfindung kann vorgesehen sein, dass wenigstens eine Nachkammer als Gaskühlkammer ausgebildet ist. So kann das Endlosmaterial vor seinem Austritt in Luft abgekühlt werden und eine unerwünschte Oxidation verhindert werden.

In einer anderen Ausführungsform der Erfindung kann vorgesehen sein, dass die Führungseinrichtung am Anfang und am Ende der Anlage jeweils eine Führungsrolle umfasst, wobei die beiden Führungsrollen vorzugsweise einen unterschiedlichen Durchmesser aufweisen.

Durch eine derartige Ausbildung von Führungsrollen können mechanische Schwingungen des Endlosmaterials, wie sie insbesondere bei höheren Durchlaufgeschwindigkeiten zu erwarten wären, vermindert werden.

In Weiterbildung der Erfindung kann vorgesehen sein, dass die Führungseinrichtung zur mechanischen Stütze ein Führungselement, vorzugsweise eine Führungsblende, eine Öse, eine Spirale oder gekreuzte Plättchen, in einem Bereich zwischen zwei Entladungskammern umfasst .So können mechanische Schwingungen des Endlosmaterials weiter reduziert werden.

In Weitergestaltung der Erfindung kann vorgesehen sein, dass die Vakuumpumpen mit den Vorkammern und dem Nachkammersystem derart aufeinander abgestimmt sind, dass eine Druckstufung einstellbar ist, die das Eindringen von Umgebungsluft in die Entladungskammern verhindert.

So kann auch bei relativ großen Eintritts- bzw. Austrittsöffnungen gewährleistet werden, dass die benötigte Atmosphäre in den Entladungskammern aufrecht erhalten bleibt,

In einer anderen Ausgestaltung der Erfindung kann vorgesehen sein, dass in Arbeitsrichtung vor den Vorkammern eine Vorreinigungsstufe mit Grobtrocknung angeordnet ist.

Durch eine derartige Vorreinigung kann die Prozessdauer in der Entladungskammer kürzer gehalten werden und die Prozessgeschwindigkeit daher weiter erhöht werden Vor allem werden Service- bzw. Reinigungsarbeiren der Anlage seltener notwendig sein.

Weiters kann vorgesehen sein, dass in Arbeitsrichtung nach dem Nachkammersystem eine Flüssigkeitskühlstufe, insbesondere eine Wasserkühlstufe, angeordnet ist.

Eine derartige Kühlstufe ermöglicht eine besonders rasche Abkühlung des Endlosmaterials und verhindert daher besonders zuverlässig seine unerwünschte Oxidation an der Luft

Die Erfindung wird unter Bezugnahme auf die beigeschlossenen Zeichnungen, in welchen Ausführungsformen dargestellt sind, näher beschrieben. Dabei zeigt:
Fig. 1 den Querschnitt durch eine Anlage zur Plasmaprozessierung mit einer Permanentmagnetanordnung mit Eisenschlusselementen,
Fig. 2 den Längsschnitt durch eine Anlage gemäß Fig. 1,
Fig. 3 bis 5 weitere Querschnitte durch Pelmaneritmagnetanordnungen mit Eisenschlusselementen,
Fig. 6 einen Längsschnitt durch eine Permanentmagnetanordnung mit Eisenschlusselementen,
Fig 7 einen Längsschnitt durch eine Anlage zur Plasmaprozessierung von Endlosmaterial.
Fig. 8 einen Längsschnitt durch eine weitere Ausführungsform einer Anlage zur Plasmaprozessierung von Endlosmaterial.

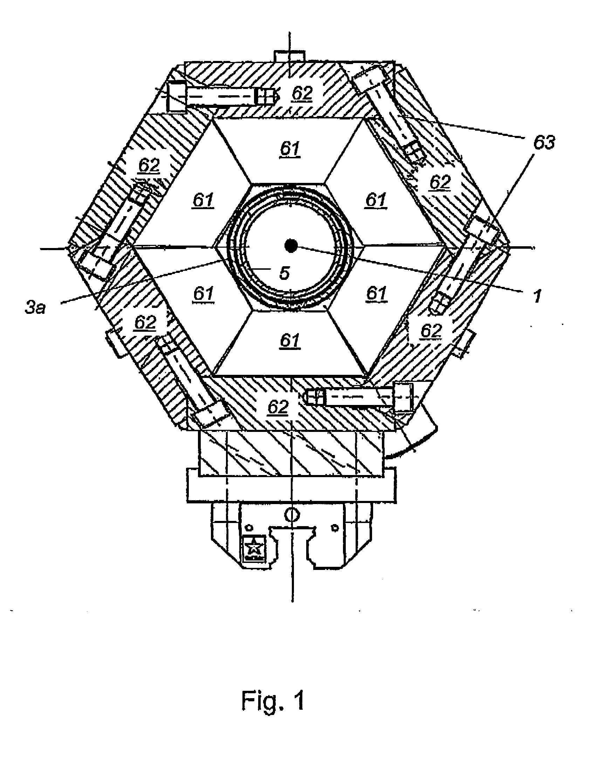

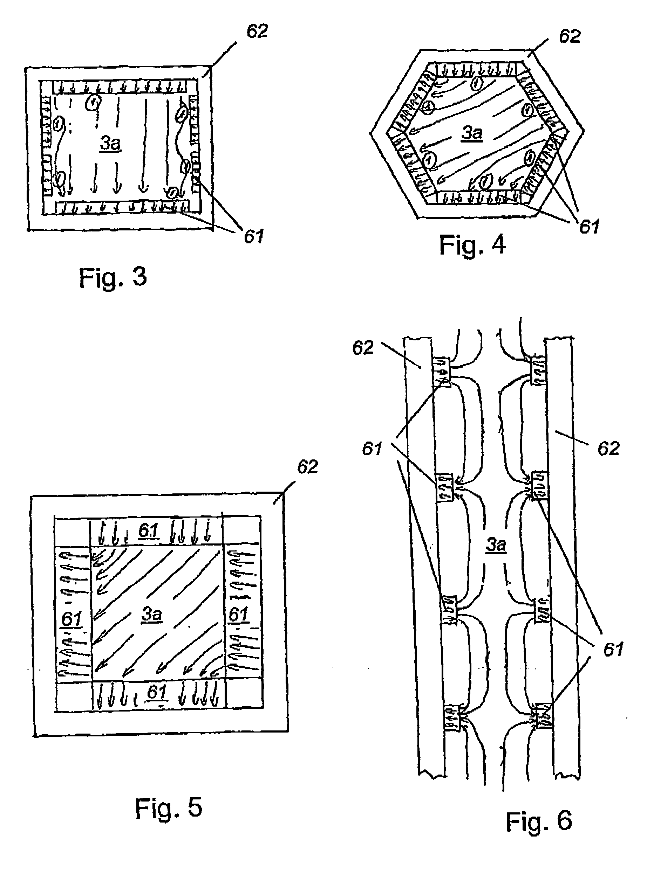

Fig. 1 zeigt den Schnitt durch eine erfindungsgemäße Anlage, die in Folge von innen nach außen beschrieben wird. Das zu prozessierende Material ist hier ein Endlosmaterial 1, das von einer äußeren Elektrode 5 umgeben ist und das durch eine die äußere Elektrode 5 umschließende Entladungskammer 3a geführt wird. Die Entladungskammer ist von einer Permanentmagentanordung 6 umgeben, die hier aus sechs Permanentmagneten 61 zusammengesetzt ist. Permanentmagentanordung 6 kann auch innerhalb der äußeren Elektrode 5 angeordnet sein. Die Permanentmagnete 61 sind vorzugsweise aus anisotropem Material, weisen also eine Vorzugsorientierung auf. Solche anisotrope Permanentmagnete 61 können nämlich stärker magnetisiert werden, als isotrope. Insbesondere Permanentmagnete 61 aus einer NdFeB-Legierung sind hier gut geeignet. Die sechs Permanentmagnete 61 bilden hier im Wesentlichen ein Sechseck. Es sind unterschiedliche Magnetisierungsrichtungen der Permanentmagnete 61 denkbar. Eine mögliche Variante der Polarisierungsanordnung, die eingermaßen homogene Feldbereiche in der Entladungskammer 3a erzeugt, ist in Fig. 6 dargestellt.

Zur besseren Bündelung des Magnetfeldes innerhalb der Entladungskammer 3a können Eisenschlusselemente 62 vorgesehen sein, die um die Permanentmagnetanordnung 6 herum angeordnet sind, diese Eisenschlusselemente 62 können mit Befestigungen 63 fest zusammengeschlossen sein, wobei die Befestigungen 63 auch lösbar, zum Beispiel als Schrauben, ausgeführt sein können. Eine mechanisch stabile Anordnung von Permanentmagneten 61 bzw. Eisenschlusselementen 62 kann auch innerhalb eines Stahlrohres erfolgen.

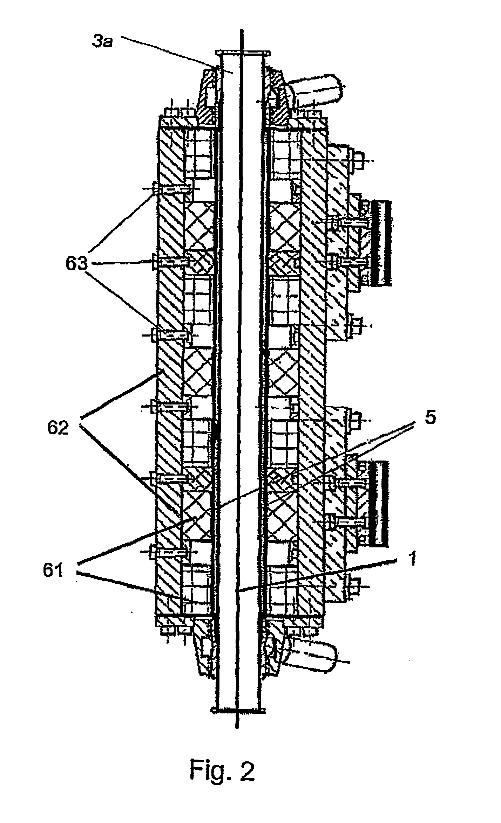

Fig. 2 zeigt die gleiche Anlage, wie in Fig. 1, im Längsschnitt. Die unterschiedlich schraffierten Permanentmagnete 61 deuten unterschiedliche Magnetisierungsrichtungen derselben an. Eine mögliche Magnetisierungsanordnung ist in Fig. 6 dargestellt.

Fig. 3 bis 5 zeigen Querschnitte durch Anordnungen von Permanentmagneten 61 mit Eisenschlusselementen 62, wobei durch die dargestellten Pfeile in den Permanentmagneten 61 Beispiele für mögliche Magnetisierungsrichtungen angedeutet sind. Die Pfeile jeweils innerhalb der Entladungskammer 3a symbolisieren die magnetischen Feldlinien in derselben. Neben den dargestellten rechteckigen und sechseckigen Querschnitten sind auch andere polygonale Geometrien für Anordnungen von Permanentmagneten 61 denkbar.

Mittels zeitlich begrenzter Stromverläufe, die um jeweils einen Permanentmagneten 61 geschickt werden, kann die Magnetisierungsstärke bzw. -Richtung verändert werden. So können mit einer einzigen Anordnung von Permanentmagneten 61 unterschiedliche Magnetfelder in einer Entladungskammer 3 a erzeugt werden.

Es ist aber auch denkbar, durch eine Veränderung der Anordnung (Entfernung, Austausch, Verschieben oder Verdrehen) von Permanentmagneten 61 bzw. Eisenschlusselementen 62 ein Magnetfeld auf benötigte Geometrien und Prozesse abzustimmen.

Um eine Überhitzung der Hochleistungsmagnetanordnung zu unterbinden, die zu einer Beeinträchtigung des zu erzeugenden Magnetfeldes führen könnte, kann ein Kühlung der Hochleistungsmagnetanordnung vorgesehen sein. Hier ist sowohl eine Flüssigkeitskühlung als auch eine Gaskühlung, vorzugsweise eine Luftkühlung, denkbar.

Starke Magnetfelder lassen sich auch durch supraleitende Elektromagnete erzeugen, die anstelle einer Permanentmagnetanordnung 6 als Hochleistungsmagnetanordnung vorgesehen sein können. Solche supraleitende Elektromagnete können durch Variation der diese durchfließenden Stromstärke und der Stromrichtung ebenfalls zur Erzeugung unterschiedlich ausgeprägter Magnetfelder innerhalb einer Entladungskammer 3a herangezogen werden.

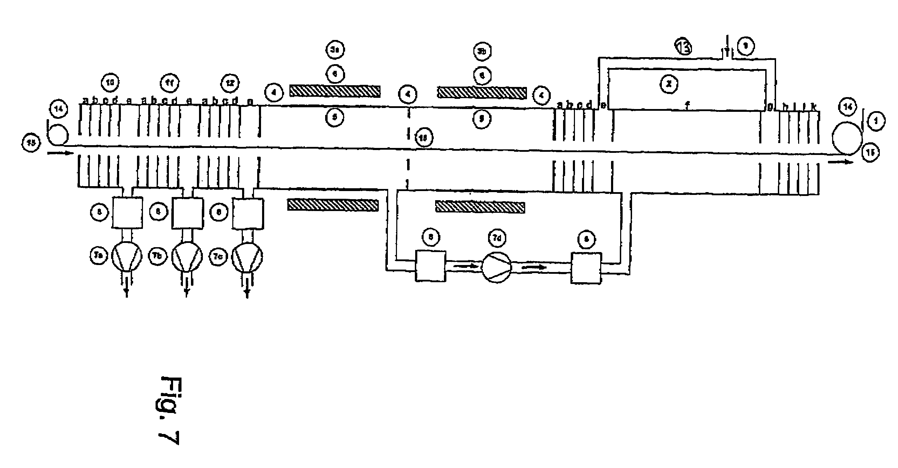

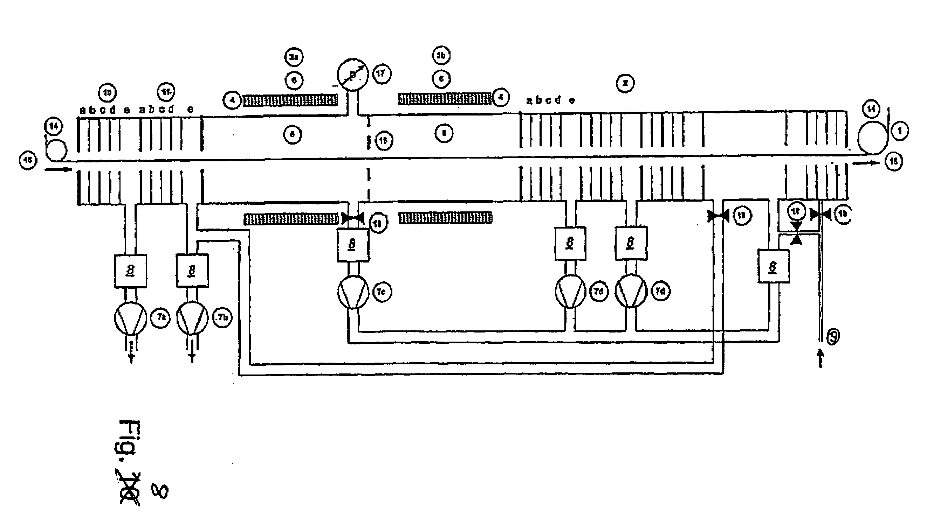

Fig. 7 und Fig. 8 zeigen Ausführungsbeispiele einer Anlage zur Plasmaprozessierung von Endlosmaterial 1. Nach zwei oder drei Vorkammersystemen 10, 11, 12, die je aus mehreren Unterkammern bestehen, z.B. 10a, 10b... , und jeweils an der letzten Unterkammer 10e, 11e, 12e ausgepumpt werden, geht das Endlosmaterial 1 durch zwei Entladungskammern 3a, 3b, zu dem Nachkammersystem 2a ... 2k. Dieses besteht aus einer langen Nachkammer 2f, die als Gaskühlstrecke fungiert, sowie vor- und nachgeschalteten kleinen Kammern, die wiederum miteinander durch Schleusenöffnungen verbunden sind. Die Vielzahl an Schleusenöffnungen in Kombination mit einer einstellbaren Druckstufung minimiert den Gasfluss, den Gasverbrauch und die nötige Pumpleistung. Das Gas strömt aus dem Nachkammernsystem 2 in die zweite Entladungskammer 3b, danach wird der Gasfluss aufgespaltet. Ein Großteil wird durch eine Vakuumpumpe 7d, der Filter 8 vor- und nachgeschaltet sind, zurück in die als Gasküblstrecke ausgeführte Nachkammer 2f geleitet. Ein kleiner Teil des Gases strömt in die erste Entladungskammer 3a und gelangt durch die letzte Schleuse der dritten Vorkammer 12e über die Pumpe 7c nach außen. Hiermit wird gewährleistet, dass die zweite Entladungskammer 3b mit sehr sauberem Gas arbeitet, wogegen die Mehrzahl der Ausdampfungen, die ja aus dem Endlosmaterial 1 in der ersten Entladungskammer 3a freigesetzt werden, mit einer relativ kleine Menge des Arbeitsgases vermischt über eine Vakuumpumpe 7c nach außen gelangt. Die Gaszuführung 9 in die gesamte Anlage erfolgt durch die Querzuleitung 13 mit einem relativ sehr kleinen Überdruck gegenüber dem Atmosphärendruck (z.B.: 0,1 bar). Der Druck in der als Gaskühlstrecke ausgebildeten Nachkammer 2f ist dagegen wesentlich größer, was dort eine bessere Kühlleistung des Endlosmaterials 1 zu Folge hat. So kann ein Rückgewinnungssystem verwirklicht werden, bei dem Gas aus einer Entladungskammer 3a, 3b in eine Vorkammer 10, 11, 12 und/oder Nachkammer 2a ... 2k mit höherem Druckniveau umgewälzt wird. Als Arbeitsgas fungiert hier beispielsweise Helium. Ein Rückgewinnungssystem wie in Fig. 8 dargestellt hat sich durch besondere Effizienz bewährt.

Das Endlosmaterial 1 sei ein Edelstahldraht, der beispielsweise auf 1100 Grad Celsius geglüht wird. Die Entladungskammern 3a, 3b bestehen jeweils aus einem 2m langen und 7cm durchmessenden Edelstahlrohr, das gleichzeitig Gefäßwand und die äußere Elektrode 5 bildet sowie einem Quarzglasrohr 4, das dicht an die äußere Elektrode 5 anschließt und die elektrische Isolierung der äußeren Elektroden 5 gewährleistet. Das Magnetfeld wird durch zwei rohrförmige Permanentmagnetanordnungen 6 erzeugt, die außerhalb der Entladungskammern 3a, 3b konzentrisch angeordnet sind. Zwischen den Entladungskammern 3a, 3b und den Permanentmagnetanordnungen 6 befindet sich eine Kühlfff9ssigkeit. Die beiden Permanentmagnetanordnungen 6 sind jeweils in der Längsrichtung magnetisiert und so angeordnet, dass die gleichnamigen Pole gegeneinander gerichtet sind. Dadurch wird erreicht, dass in der Symmetrieebene zwischen den beiden Entladungskammern 3a, 3b kein Magnetfeld herrscht. Man kann daher das Endlosmaterial, 1 dort mechanisch "stützen" (z.B. durch ein Führungselement 16, vorzugsweise eine Führungsblende, eine Öse, eine Spirale oder gekreuzte Plättchen) und damit am Schwingen hindern, ohne das eine Entladung zu diesem Führungselement 16 brennt.

Als Spannung zwischen den äußeren Elektroden 5 der beiden Entladungskammern 3a, 3b und dem Endlosmaterial 1 wird eine Gleichspannung, insbesondere eine gepulste Gleichspannung, angelegt, die in eigenen Energieversorgungseinrichtungen (nicht eingezeichnet) erzeugt wird. So kann eine weitere Energiedichtenerhöhung durch Pulsentladungen, z.B. mittels eines Rechteckssignals mit beispielsweise ca. 300V Amplitude und ca. 25kHz Pulsfrequenz, erzielt werden. Es können auch andere Werte für die Amplitude und die Pulsfrequenz gewählt werden, wobei die Pulse z.T. auch umgekehrte Polarität aufweisen können. Eine gepulste Gleichspannung unterdrückt die unerwünschte Ausbildung von Bogenentladungen mit Brennfleck.

Die Führungsrollen 14 sind geerdet und kontaktieren (erden) das Endlosmaterial 1. Sie weisen idealer weise ein Radiusverhältnis von 5:7 auf. Sowohl die Entladungskammern 3a, 3b wie auch die Endlosmaterial-Gaskühlstrecke 2 werden beispielsweise mittels Öl flüssigkeitsgekühlt. Das Öl wird von einer Pumpe umgewälzt und kühlt sich im Flüssigkeitsbehälter einer Endlosmaterial-Vorreinigungsstufe, insbesondere mit Grobtrocknung, durch einen Wärmetauscher auf die Siedetemperatur der Vorreinigungsflüssigkeit (Wasser oder Wasser mit Reinigungsmitteln) ab. Auf diese Weise wird sowohl die Vorreinigungsflüssigkeit erhitzt, als auch die Temperaturen der Entladungskammern 3a, 3b und die der Gaskühlstrecke 2f konstant gehalten. In der ersten Nachkammer 2a befindet sich ein Strahlungsdetektor, der die Wärmestrahlung des Endlosmaterials 1 aufnimmt und daraus die Oberflächentemperatur des Endlosmaterials 1 ermittelt. Nach dem Nachkammersystem kann weiters eine Flüssigkeitskühlstufe, insbesondere eine Wasserkühlstufe, vorgesehen sein. Der ganze Prozess kann über ein Regel- bzw. Steuersystem 17, wie einer Prozesssteuerung SPS, oder auch einfacher Regel- bzw. Steuersysteme, und über insbesondere regel- bzw. steuerbare Ventile 18 kontrolliert werden. Für eine effiziente Plasmaprozessierung eignen sich unterschiedliche Gase in Kombination mit unterschiedlichen Drücken und Magnetfeldstärken. Einige dieser Kombination sind beispielhaft angegeben.

| | 100mT | 500mT | Bemerkung zu Gas |
|---|---|---|---|
| He | ~5mbar | ~25mbar | gute Kühleigenschaften und höchste Leistungsdichten |
| Ar | ~2,5mbar | ~12,5mbar | kostengünstig und betriebssicher |
| N₂ | ~0,5mbar | ~2,5mbar | kostengünstig und betriebssicher, zur Nitrierung geeignet |
| H₂ | | | gute Kühleigenschaften, explosiv |

Auch Gasgemische können zur Plasmaprozessierung eingesetzt werden. So ist beispielsweise eine Beimengung von etwa ein bis drei Prozent Wasserstoff zu einer Heliumatmosphäre sinnvoll, um die Vorteile der guten Ionisierbarkeit von Wasserstoff zu nutzen, während der überwiegende Anteil Helium die Betriebssicherheit gewährleistet.

Als Arbeitsgase können auch ganz allgemein Edelgase, insbesondere Helium. Argon oder Krypton, mit einer Beimengung von vorzugsweise ein bis zehn, speziell ein bis drei Prozent, eines chemisch wirksamen, insbesondere oxidierenden oder reduzierenden, Gases oder Dampfes, wie beispielsweise Wasserstoff, ein Alkohol oder ein Alkan, eingesetzt werden, wofür jeweils die entsprechenden Drücke einstellbar sind.

Die entsprechenden optimalen Drücke werden über Vakuumpumpen 7a bis 7d, vorzugsweise kostengünstige Drehschieberpumpen, und gegebenenfalls über Filter 8 und Ventile 18 erzeugt, womit bei gegebenem Magnetfeld der benötigte Druck zur Konzentration des Plasmastromes im Bereich des Magnetfeldes erzielt werden kann.

## Patentansprüche

1. Anlage zur magnetfeldbeeinflussten Plasmaprozessierung eines Endlosmaterials (1), umfassend wenigstens eine evakuierbare Entladungskammer (3a, 3b), darin eine äußere Elektrode (5), insbesondere Anode, die elektrisch isoliert um das Endlosmaterial (1) angeordnet ist, eine Einrichtung zur Einstellung einer Gas-Atmosphäre in der wenigstens einen Entladungskammer (3a, 3b), eine Energieversorgungseinrichtung zur Bereitstellung einer(s) für eine Gasentladung zwischen dem Endlosmaterial (1) als innere Elektrode, insbesondere Kathode, und der äußeren Elektrode (5) ausreichenden Spannung bzw. Stroms, wobei zur beträchtlichen Erhöhung der erzielbaren Energiedichte der Gasentladung im Bereich der äußeren Elektrode (5), vorzugsweise außerhalb der äußeren Elektrode (5), eine Hochleistungsmagnetanordnung zur Erzeugung eines Magnetfelds, insbesondere von wenigstens 50mT, vorzugsweise von wenigstens 100mT, gegebenenfalls von über 400mT, angeordnet ist, umfassend eine Führungseinrichtung (15) zum kontinuierlichen Transport des Endlosmaterials (1) durch die wenigstens eine Entladungskammer (3a, 3b), wobei das Magnetfeld der Hochleistungsmagnetanordnung im Wesentlichen parallel zum Endlosmaterial (1) ausgerichtet ist, wobei die Einrichtung zur Einstellung einer Gas-Atmosphäre ein Vorkammern- (10, 11, 12) und ein Nachkammernsystem (2) umfasst, wobei zwischen den Kammern (2, 3a, 3b, 10, 11, 12) dieser Systeme Schleusenöffnungen vorgesehen sind, durch welche das Endlosmaterial (1) reibungsarm durch das Vorkammem-(10, 11, 12) und das Nachkammernsystem (2) hindurch führbar ist, **dadurch gekennzeichnet, dass** die Einrichtung zur Einstellung einer Gas-Atmosphäre ein Rückgewinnungssystem umfasst, bei dem Gas aus einer Nachkammer (2a ... 2k) in eine Vorkammer (10, 11, 12) und/oder Nachkammer (2a ... 2k) mit höherem Druckniveau umwälzbar ist.

2. Anlage nach Anspruch 1, **dadurch gekennzeichnet, dass** die Hochleistungsmagnetanordnung als supraleitender Elektromagnet ausgebildet ist.

3. Anlage nach Anspruch 1, **dadurch gekennzeichnet, dass** die Hochleistungsmagnetanordnung als Permanentmagnetanordnung (6) ausgebildet ist.

4. Anlage nach Anspruch 3, **dadurch gekennzeichnet, dass** die Permanentmagnetanordnung (6) aus Permanentmagneten (61), insbesondere aus anisotropen Permanentmagneten, vorzugsweise aus NdFeB-Permanentmagneten, ausgebaut ist, welche im Wesentlichen die Seitenwände eines Prismas mit polygonalem Querschnitt bilden.

5. Anlage nach Anspruch 4, **dadurch gekennzeichnet, dass** der Querschnitt des Prismas als Quadrat oder Sechseck ausgebildet ist.

6. Anlage nach Anspruch 3, 4 oder 5, **dadurch gekennzeichnet, dass** Eisenschlusselemente (62) vorgesehen sind, die das Magnetfeld der Permanentmagnetanordnung (6) im Bereich der Gasentladung konzentrieren.

7. Anlage nach Anspruch 6, **dadurch gekennzeichnet, dass** die Permanentmagnete (61) jeweils im Wesentlichen normal zu an diese angrenzenden Eisenschlusselemente (62) angeordnet sind, sodass jeweils genau ein Pol eines Permanentmagnetes (61) am Eisenschlusselement (62) anliegt.

8. Anlage nach einem der Ansprüche 3 bis 7, **dadurch gekennzeichnet dass** eine Vorrichtung zur Abstimmung der Magnetfelder der Permanentmagnete (61) mittels definierter begrenzter Stromverläufe vorgesehen ist.

9. Anlage nach einem der Ansprüche 3 bis 8, **dadurch gekennzeichnet, dass** wenigstens ein Permanentmagnet (61) und/oder wenigstens ein Eisenschlusselement (62) entfernbar, ersetzbar, verschiebbar oder verdrehbar angeordnet ist.

10. Anlage nach einem der Ansprüche 1 bis 9, **dadurch gekennzeichnet, dass** die äußeren Elektroden (5) und/oder die Hochleistungsmagnetanordnung kühlbar, insbesondere flüssigkeitskühlbar, sind.

11. Anlage nach einem der Ansprüche 1 bis 10, **dadurch gekennzeichnet, dass** die Einrichtung zur Einstellung einer Gas-Atmosphäre ein Regel- bzw. Steuersystem (17) mit Vakuumpumpen (7a - 7d), vorzugsweise Drehschieberpumpen, und/oder Ventilen (18) umfasst, mit denen die Gas-Atmosphäre auf einen auf ein gewähltes Gas abgestimmten Druck einstellbar ist.

12. Anlage nach Anspruch 11, **dadurch gekennzeichnet, dass** die Einrichtung zur Einstellung einer Gas-Atmosphäre auf Edelgase, insbesondere auf Helium, einstellbar ist.

13. Anlage nach Anspruch 11 oder 12, **dadurch gekennzeichnet, dass** die Einrichtung zur Einstellung einer Gas-Atmosphäre auf Edelgase, insbesondere auf Helium, Argon oder Krypton, mit einer Beimengung von vorzugsweise ein bis zehn, speziell ein bis drei Prozent, eines chemisch wirksamen, insbesondere oxidierenden oder reduzierenden, Gases oder Dampfes, wie beispielsweise Wasserstoff, ein Alkohol oder ein Alkan, einstellbar ist.

14. Anlage nach einem der Ansprüche 1 bis 13, **dadurch gekennzeichnet, dass** die Energieversorgungseinrichtung auf Gleichspannung, insbesondere gepulste Gleichspannung, zwischen äußerer Elektrode (5) und Endlosmaterial (1) abgestimmt ist, wobei die Pulse z.T. auch umgekehrte oder wechselnde Polarität aufweisen können.

15. Anlage nach einem der Ansprüche 1 bis 14, **dadurch gekennzeichnet, dass** die Vorkammern (10, 11, 12) in Unterkammern (a, b, c...) unterteilt sind und/oder das Nachkammernsystem (2) aus einzelnen Nachkammern (2a ... 2k) zusammengesetzt ist, wobei zwischen den Unterkammern (a, b, c...) bzw. den Nachkammern (2a ... 2k) Schleusenöffnungen vorgesehen sind, über welche das Endlosmaterial (1) reibungsarm durch die Unterkammern (a, b, c...) bzw. die Nachkammern (2a ... 2k) hindurch führbar ist.

16. Anlage nach Anspruch 15, **dadurch gekennzeichnet, dass** wenigstens eine Nachkammer (2f) als Gaskühlkammer ausgebildet ist.

17. Anlage nach einem der Ansprüche 1 bis 16, **dadurch gekennzeichnet, dass** die Führungseinrichtung (15) am Anfang und am Ende der Anlage jeweils eine Führungsrolle (14) umfasst, wobei die beiden Führungsrollen (14) vorzugsweise einen unterschiedlichen Durchmesser aufweisen.

18. Anlage nach einem der Ansprüche 1 bis 17, **dadurch gekennzeichnet, dass** die Führungseinrichtung (15) zur mechanischen Stütze ein Führungselement (16), vorzugsweise eine Führungsblende, eine Öse, eine Spirale oder gekreuzte Plättchen, in einem Bereich zwischen zwei Entladungskammern (3a, 3b) umfasst.

19. Anlage nach einem der Ansprüche 11 bis 18, **dadurch gekennzeichnet, dass** die Vakuumpumpen (7a - 7d) mit den Vorkammern (10, 11, 12) und dem Nachkammersystem, (2) derart aufeinander abgestimmt sind, dass eine Druckstufung einstellbar ist, die das Eindringen von Umgebungsluft in die Entladungskammern (3a, 3b) verhindert.

20. Anlage nach einem der Ansprüche 1 bis 20, **dadurch gekennzeichnet, dass** in Arbeitsrichtung vor den Vorkammern (10, 11, 12) eine Vorreinigungsstufe mit Grobtrocknung angeordnet ist.

21. Anlage nach einem der Ansprüche 1 bis 20, **dadurch gekennzeichnet, dass** in Arbeitsrichtung nach dem Nachkammersystem (2) eine Flüssigkeitskühlstufe, insbesondere eine Wasserkühlstufe, angeordnet ist.

## Claims

1. An installation for the plasma processing influenced by a magnetic field of a continuous material (1), comprising at least one evacuatable discharge chamber (3a, 3b), with an external electrode (5) contained therein, in particular an anode that is electrically insulated and arranged around the continuous material (1), a device for setting a gas atmosphere in the at least one discharge chamber (3a, 3b), an energy supply device for providing a voltage or a current, respectively, which is sufficient for a gas discharge between the continuous material (1) acting as an internal electrode, in particular as a cathode, and the external electrode (5), wherein, in order to significantly increase the obtainable energy density of the gas discharge, a high-performance magnet assembly for generating a magnetic field, in particular of at least 50 mT, preferably of at least 100 mT, optionally in excess of 400 mT, is arranged in the area of the external electrode (5), preferably outside of the external electrode (5), comprising a guide means (15) for the continuous transport of the continuous material (1) through the at least one discharge chamber (3a, 3b), with the magnetic field of the high-performance magnet assembly being oriented essentially parallel to the continuous material (1), wherein the device for setting a gas atmosphere comprises a prechamber system (10, 11, 12) and a postchamber system (2), with sluice openings being provided between the chambers (2, 3a, 3b, 10, 11, 12) of said systems, through which openings the continuous material (1) can be guided with low friction through the prechamber system (10, 11, 12) and the postchamber system (2), **characterized in that** the device for setting a gas atmosphere comprises a recovery system wherein gas can be recirculated from a postchamber (2a ... 2k) into a prechamber (10, 11, 12) and/or postchamber (2a ... 2k) having a higher pressure level.

2. An installation according to claim 1, **characterized in that** the high-performance magnet assembly is designed as a superconducting electromagnet.

3. An installation according to claim 1, **characterized in that** the high-performance magnet assembly is designed as a permanent magnet assembly (6).

4. An installation according to claim 3, **characterized in that** the permanent magnet assembly (6) is composed of permanent magnets (61), in particular of anisotropic permanent magnets, preferably of NdFeB permanent magnets, which essentially form the side walls of a prism having a polygonal cross-section.

5. An installation according to claim 4, **characterized in that** the cross-section of the prism is configured as a square or a hexagon.

6. An installation according to claim 3, 4 or 5, **characterized in that** iron yoke elements (62) are provided which concentrate the magnetic field of the permanent magnet assembly (6) in the area of the gas discharge.

7. An installation according to claim 6, **characterized in that** the permanent magnets (61) are each arranged essentially normal to iron yoke elements (62) located adjacent to them so that in each case exactly one pole of a permanent magnet (61) abuts the iron yoke element (62).

8. An installation according to any of claims 3 to 7, **characterized in that** a device for adjusting the magnetic fields of the permanent magnets (61) by means of defined restricted current flows is provided.

9. An installation according to any of claims 3 to 8, **characterized in that** at least one permanent magnet (61) and/or at least one iron yoke element (62) is/are arranged in a removable, replaceable, displaceable or twistable fashion.

10. An installation according to any of claims 1 to 9, **characterized in that** the external electrodes (5) and/or the high-performance magnet assembly are coolable, in particular liquid-coolable.

11. An installation according to any of claims 1 to 10, **characterized in that** the device for setting a gas atmosphere comprises a regulating or control system (17), respectively, comprising vacuum pumps (7a - 7d), preferably slide vane rotary pumps, and/or valves (18), by means of which the gas atmosphere can be adjusted to a pressure adapted to a selected gas.

12. An installation according to claim 11, **characterized in that** the device for setting a gas atmosphere can be adjusted to noble gases, especially to helium.

13. An installation according to claim 11 or 12, **characterized in that** the device for setting a gas atmosphere can be adjusted to noble gases, in particular to helium, argon or krypton, with an addition of preferably one to ten, especially one to three, percent of a chemically active, in particular oxidizing or reducing, gas or vapour such as, for example, hydrogen, an alcohol or an alkane.

14. An installation according to any of claims 1 to 13, **characterized in that** the energy supply device is adjusted to a direct-current voltage, in particular to a pulsed direct-current voltage, between the external electrode (5) and the continuous material (1), wherein the pulses can partly also have reversed or varying polarities.

15. An installation according to any of claims 1 to 14, **characterized in that** the prechambers (10, 11, 12) are divided into subchambers (a, b, c...) and/or the postchamber system (2) is composed of individual postchambers (2a ... 2k), with sluice openings being provided between the subchambers (a, b, c...) and the postchambers (2a ... 2k), respectively, via which openings the continuous material (1) can be guided with low friction through the subchambers (a, b, c...) and the postchambers (2a ... 2k), respectively.

16. An installation according to claim 15, **characterized in that** at least one postchamber (2f) is designed as a gas cooling chamber.

17. An installation according to any of claims 1 to 16, **characterized in that** the guide means (15) comprises one guide pulley (14) each at the beginning and at the end, respectively, of the installation, the two guide pulleys (14) preferably having different diameters.

18. An installation according to any of claims 1 to 17, **characterized in that** the guide means (15) comprises a guide element (16) to provide mechanical support, preferably a guide aperture, a lug, a coil or crossed plates, in an area between two discharge chambers (3a, 3b).

19. An installation according to any of claims 11 to 18, **characterized in that** the vacuum pumps (7a- 7d) are aligned with the prechambers (10, 11, 12) and the postchamber system (2) such that a pressure gradation can be adjusted, preventing ambient air from entering the discharge chambers (3a, 3b).

20. An installation according to any of claims 1 to 20, **characterized in that** a prepurification stage comprising coarse drying is arranged in the working direction prior to the prechambers (10, 11, 12).

21. An installation according to any of claims 1 to 20, **characterized in that** a liquid cooling stage, in particular a water cooling stage, is arranged in the working direction after the postchamber system (2).

## Revendications

1. Installation pour le traitement d'un matériau sans fin (1) au plasma et sous l'influence d'un champ magnétique, comprenant au moins une chambre de décharge (3a, 3b) susceptible d'être évacuée, dans celle-ci une électrode extérieure (5), en particulier une anode, qui est agencée de façon électriquement isolée autour du matériau sans fin (1), des moyens pour établir une atmosphère gazeuse dans ladite au moins une chambre d e décharge (3a, 3 b), d es moyens d'alimentation en énergie pour appliquer une tension ou un courant suffisant(e) pour une décharge gazeuse entre le matériau sans fin (1) en guise d'électrode intérieure, en particulier de cathode, et l'électrode extérieure (5), et pour augmenter considérablement la densité d'énergie susceptible d'être atteinte dans la décharge gazeuse, un agencement magnétique à haute puissance pour générer un champ magnétique, en particulier d'au moins 50 mT, de préférence d'au moins 100 mT, le cas échéant de plus de 400 mT est agencé dans la région de l'électrode extérieure (5), de préférence à l'extérieur de l'électrode extérieure (5), comprenant un dispositif de guidage (15) pour transporter en continu le matériau sans fin (1) à travers la dite au moins une chambre de décharge (3a, 3b), le champ magnétique de l'agencement magnétique à haute puissance étant orienté essentiellement parallèlement au matériau sans fin (1), et les moyens pour établir une atmosphère gazeuse comprennent un système à chambre préliminaire (10, 11, 12) et un système à chambre postérieure (2), des ouvertures de sas étant prévues entre les chambres (2, 3a, 3b, 10, 11, 12) de ces systèmes, à travers lesquelles le matériau sans fin (1) peut être mené avec peu de friction à travers le système à chambre préliminaire (10, 11, 12) et le système à chambre postérieure (2), **caractérisée en ce que** les moyens pour établir une atmosphère gazeuse comprennent un système de récupération dans lequel le gaz peut être recyclé à partir d'une chambre postérieure (2a ... 2k) jusque dans une chambre préliminaire (10, 11, 12) et/ou une chambre postérieure (2a ... 2k) avec un niveau de pression plus élevé.

2. Installation selon la revendication 1, **caractérisée en ce que** l'agencement magnétique à haute puissance est réalisé sous la forme d'un électroaimant supraconducteur.

3. Installation selon la revendication 1, **caractérisée en ce que** l'agencement magnétique à haute puissance est réalisé sous forme d'agencement à aimant permanent (6).

4. Installation selon la revendication 3, **caractérisée en ce que** l'agencement à aimant permanent (6) est réalisé avec des aimants permanents (61), en particulier des aimants permanents anisotropes, de préférence des aimants permanents NdFeB, qui forment essentiellement les parois latérales d'un prisme à section polygonale.

5. Installation selon la revendication 4, **caractérisée en ce que** la section du prisme est en forme de carré ou d'hexagone.

6. Installation selon la revendication 3, 4 ou 5, **caractérisée en ce qu'**il est prévu des éléments de fermeture en fer (62) qui concentrent le champ magnétique de l'agencement à aimant permanent (6) dans la zone de la décharge gazeuse.

7. Installation selon la revendication 6, **caractérisée en ce que** les aimants permanents (61) sont agencés respectivement essentiellement perpendiculairement aux éléments de fermeture en fer (62) qui leur sont limitrophes, de sorte qu'à chaque fois exactement un pôle d'un aimant permanent (61) est appliqué contre l'élément de fermeture en fer (62).

8. Installation selon l'une des revendications 3 à 7, **caractérisée en ce qu'**il est prévu un dispositif pour accorder le champ magnétique des aimants permanents (61) au moyen d'évolutions définies limitées du courant.

9. Installation selon l'une des revendications 3 à 8, **caractérisée en ce qu'**au moins un aimant permanent (61) et/ou au moins un élément de fermeture en fer (62) est agencé de façon à pouvoir être enlevé, remplacé, déplacé en translation ou déplacé en rotation.

10. Installation selon l'une des revendications 1 à 9, **caractérisée en ce que** les électrodes extérieures (5) et/ou l'agencement magnétique à haute puissance sont susceptibles d'être refroidis, en particulier d'être refroidis par un liquide.

11. Installation selon l'une des revendications 1 à 10, **caractérisée en ce que** les moyens pour établir une atmosphère gazeuse comprennent un système de régulation ou de commande (17) avec des pompes à vide (7a-7d), en particulier des pompes à tiroirs rotatifs, et/ou des valves (18) au moyen desquelles l'atmosphère gazeuse peut être réglée à une pression accordée à un gaz choisi.

12. Installation selon la revendication 11, **caractérisée en ce que** les moyens pour établir une atmosphère gazeuse sont susceptibles d'être mis au point avec des gaz nobles, en particulier de l'hélium.

13. Installation selon la revendication 11 ou 12, **caractérisée en ce que** les moyens pour établir une atmosphère gazeuse sont susceptibles d'être mis au point avec des gaz nobles, en particulier de l'hélium, de l'argon ou du krypton, avec addition d'un gaz ou d'une vapeur, comme par exemple de l'hydrogène, un alcool ou un alcane actif sur le plan chimique, en particulier oxydant ou réducteur, de préférence à raison de 1 à 10 % et spécialement de 1 à 3 %.

14. Installation selon l'une des revendications 1 à 13, **caractérisée en ce que** les moyens d'alimentation en énergie sont accordés à une tension continue, en particulier une tension continue pulsée, entre l'électrode extérieure (5) et le matériau sans fin (1), les impulsions pouvant également en partie présenter une polarité inversée ou alternante.

15. Installation selon l'une des revendications 1 à 14, **caractérisée en ce que** les chambres préliminaires (10, 11, 12) sont subdivisées en sous-chambres (a, b, c, ...) et/ou le système de chambre postérieure (2) est composé de chambres postérieures individuelles (2a ... 2k), des ouvertures de sas étant prévues entre les sous-chambres (a, b, c, ...) ou les chambres postérieures (2a ... 2k), via lesquelles le matériau sans fin (1) peut être mené avec peu de friction à travers les sous-chambres (a, b, c) ou à travers les chambres postérieures (2a ... 2k).

16. Installation selon la revendication 15, **caractérisée en ce qu'**au moins une chambre postérieure (2f) est réalisée sous forme de chambre de refroidissement de gaz.

17. Installation selon l'une des revendications 1 à 16, **caractérisée en ce que** le dispositif de guidage (15) au début et à la fin de l'installation comprend à chaque fois un rouleau de guidage (14), les deux rouleaux de guidage (14) présentant de préférence un diamètre différent.

18. Installation selon l'une des revendications 1 à 17, **caractérisée en ce que** le dispositif de guidage (15) comprend, pour un soutien mécanique, un élément de guidage (16), de préférence un diaphragme de guidage, un oeillet, une spirale où des plaquettes en croix, dans une zone entre deux chambres à décharge (3a, 3b).

19. Installation selon l'une des revendications 11 à 18, **caractérisée en ce que** les pompes à vide (7a-7d) sont accordées aux chambres préliminaires (10, 11, 12) et au système à chambre postérieure (2) de telle façon qu'il est possible de régler un échelonnement de pression qui empêche la pénétration de l'air environnant jusque dans les chambres de décharge (3a, 3b).

20. Installation selon l'une des revendications 1 à 19, **caractérisée en ce qu'**un étage de purification préliminaire avec séchage grossier est agencé devant les chambres préliminaires (10, 11, 12) en direction de travail.

21. Installation selon l'une des revendications 1 à 20, **caractérisée en ce qu'**un étage de refroidissement de liquide, en particulier un étage de refroidissement d'eau, est agencé après le système à chambre postérieure (2) en direction de travail.
